# EUROPÄISCHE PATENTSCHRIFT

(11) **EP 3 173 374 B1**
(45) Veröffentlichungstag und Bekanntmachung des Hinweises auf die Patenterteilung: **01.05.2019**
(21) Anmeldenummer: 16200607.6
(22) Anmeldetag: 24.11.2016
(51) Int. Cl.: B81B 3/00, H01H 59/00, H01H 61/02

(54) **AKTORANORDNUNG**
ACTUATOR ARRANGEMENT
SYSTÈME D'ACTIONNEUR

(30) Priorität: 25.11.2015 DE 102015120430
(43) Veröffentlichungstag der Anmeldung: 31.05.2017
(73) Patentinhaber: Technische Universität Darmstadt, 64289 Darmstadt (DE)
(72) Erfinder: Nakic, Christian, 64293 Darmstadt (DE); El Khoury, Mario, 64287 Darmstadt (DE); Staab, Matthias, 61352 Bad Homburg (DE); Winterstein, Thomas, 63743 Aschaffenburg (DE); Schlaak, Helmut F., 64372 Ober-Ramstadt (DE)
(74) Vertreter: Katscher Habermann Patentanwälte

(56) Entgegenhaltungen:
- US-A- 3 761 855
- US-A1- 2002 057 148

## Beschreibung

Die Erfindung betrifft eine Aktoranordnung mit einem ersten Aktor und mit einem zweiten Aktor, wobei der erste Aktor und der zweite Aktor jeweils ein Verformungselement aufweisen, welches jeweils an einem Befestigungsende festgelegt ist und jeweils ein dem Befestigungsende gegenüberliegendes Verformungsende aufweist, dass durch Verformung des Verformungselements relativ zu dem Befestigungsende längs einer Verformungstrajektorie ausgelenkt werden kann, wobei das erste Verformungsende des ersten Aktors durch Verformung des Verformungselements mit dem zweiten Verformungsende des zweiten Aktors in Eingriff gebracht oder von dem zweiten Verformungsende des zweiten Aktors gelöst werden kann, sodass das zweite Verformungsende des zweiten Aktors auf dem ersten Verformungsende des ersten Aktors aufliegt oder das erste Verformungsende des ersten Aktors auf dem zweiten Verformungsende des zweiten Aktors aufliegt und dadurch zwei stabile Auslenkungspositionen des zweiten Aktors vorgegeben werden, wobei in mindestens einer Auslenkungsposition des zweiten Aktors das erste Verformungsende des ersten Aktors einen ersten Verbindungsbereich mit mindestens einer ersten Anlagefläche, die eine Auslenkung des zweiten Verformungsendes des zweiten Aktors in einer ersten Auslenkungsrichtung begrenzt, und mit mindestens einer zweiten Anlagefläche aufweist, die eine Auslenkung des zweiten Verformungsendes des zweiten Aktors in einer zweiten Auslenkungsrichtung begrenzt, die der ersten Auslenkungsrichtung entgegengesetzt ist, wenn das zweite Verformungsende des zweiten Aktors mit dem ersten Verformungsende des ersten Aktors in Eingriff ist und dabei das zweite Verformungsende des zweiten Aktors an der ersten Anlagefläche des ersten Aktors anliegt, sodass durch die erste Anlagefläche und die zweite Anlagefläche des ersten Aktors eine Auslenkung des zweiten Endes des zweiten Aktors gleichzeitig in der ersten Auslenkungsrichtung und in der zweiten Auslenkungsrichtung begrenzt ist, wodurch das zweite Verformungsende des zweiten Aktors in mehreren Auslenkungspositionen mindestens drei verschiedenen Auslenkungspositionen in dem ersten Verbindungsbereich mit dem ersten Verformungsende des ersten Aktors in Eingriff gebracht werden kann.

Aktoranordnungen bieten in einer großen Anzahl von Anwendungen in völlig unterschiedlichen Verwendungsbereichen die Möglichkeit, Stellgrößen vorzugeben und zu verändern, um in einem technischen System verschiedene Zustände einstellen zu können. Einige Aktoren erlauben es, ein Stellglied des Aktors innerhalb eines vorgegebenen Stellwegs an einer beliebigen Position zu positionieren und dort festzulegen, um über seine Fixierung weiterhin Kräfte aufnehmen zu können. Bei anderen Aktoren kann das Stellglied nur diskontinuierlich verlagert und an einigen wenigen Stellpositionen innerhalb des Stellwegs festgelegt werden.

Mit Aktoren, deren Stellglied zwischen zwei Stellpositionen verlagert werden kann, können beispielsweise Schalter bzw. ganz allgemein zwei verschiedene Zustände für ein komplexes Bauteil realisiert werden, in welchem ein derartiger Aktor eingesetzt wird. Solche Aktoren, deren Stellglied zwischen zwei verschiedenen Stellpositionen verlagert werden kann, können aus wenigen Elementen kostengünstig hergestellt werden und ermöglichen oftmals über eine lange Nutzungsdauer einen zuverlässigen Betrieb des Aktors. Derartige Aktoren eignen sich in besonderer Weise auch für eine Miniaturisierung der Aktoreinrichtung, die dadurch auch bei mikrotechnologischen Anwendungsbereichen eingesetzt werden kann.

Aktoranordnungen mit zwei Stellpositionen des Stellglieds können mit einem bistabilen Mechanismus ausgestattet sein, sodass die beiden Stellpositionen jeweils stabile Zustände der Aktoranordnungen darstellen, zwischen denen das Stellglied verlagert werden kann. In jedem der beiden stabilen Stellpositionen kann das dort befindliche Stellglied mit entweder einer sehr geringen Energieaufnahme oder ohne eine zusätzliche Energieaufnahme festgelegt sein und diese stabile Stellposition beibehalten. Mit einer derartigen bistabilen Ausgestaltung einer Aktoranordnung können zwei verschiedene Stellpositionen oder Schaltzustände der Aktoranordnung äußerst energieeffizient vorgegeben und über einen langen Zeitraum beibehalten werden, da lediglich für eine Verstellung des Stellglieds Energie benötigt wird, während das Beibehalten einer stabilen Stellposition des Stellglieds ohne weitere nennenswerte Energieaufnahme möglich ist.

In vielen Fällen werden dabei mindestens zwei Aktoren in der Aktoranordnung so ausgestaltet und angeordnet, dass ein erster Aktor in dessen Ruheposition mit einem zweiten Aktor in Eingriff ist, der zwischen zwei stabilen Eingriffspositionen verlagert werden kann und als Stellglied der Aktoranordnung dient. Eine derartige Aktoranordnung ist beispielsweise in DE 10 2008 050 630 A1 beschrieben. Weitere bistabile Aktoranordnungen sind beispielsweise in US 2009 040 008 A1 oder DE 100 15 598 A1 sowie in US 2002/057148 A1 beschrieben.

Für eine Vielzahl von Anwendungen ist es jedoch zweckmäßig und vorteilhaft, wenn nicht nur zwei stabile Stellpositionen des Stellglieds vorgegeben und energieeffizient beibehalten werden können, sondern drei oder mehrere verschiedene Stellpositionen möglich sind und je nach Bedarf vorgegeben und genutzt werden können. In US 2008 223 699 A1 sind beispielsweise Anordnungen von zwei oder drei ineinander greifenden Aktoren beschrieben, mit denen ein als Stellglied dienender Mikroaktor je nach Ausgestaltung der Aktoranordnung in zwei oder drei verschiedenen Schaltzuständen festgelegt bzw. zurückgehalten werden kann. Dabei wird der als Stellglied dienende Mikroaktor jeweils durch eine mechanische Kopplung mit einem weiteren Aktor in einer stabilen Stellposition festgelegt. Für jede stabile Stellposition muss ein zugeordneter Aktor vorgesehen sein, mit welchem die mechanische Kopplung vorgenommen werden kann. Die mechanische Kopplung muss ausreichend stabil sein, um die von den miteinander gekoppelten Mikroaktoren ausgeübten Rückstellkräfte aufnehmen und die Mikroaktoren in der ausgelenkten Position zurückhalten zu können. Der für eine derartige Aktoranordnung anfallende Herstellungsaufwand ist vergleichsweise groß. Zudem wird die von der Aktoranordnung maximal aufgebrachte Aktorkraft durch die mechanische Belastbarkeit der Kopplung der betreffenden Mikroaktoren beschränkt.

In US 3,761,855 A ist eine Aktoranordnung beschrieben, bei der ein zweiter Aktor in drei verschiedenen Positionen relativ zu einem ersten Aktor festgelegt werden kann, wobei der zweite Aktor in einer Position derart mit dem ersten Aktor in Eingriff treten kann, dass dessen Auslenkung in einer ersten und in einer entgegengesetzten zweiten Auslenkungsrichtung begrenzt ist.

Es wird deshalb als eine Aufgabe der vorliegenden Erfindung angesehen, eine Aktoranordnung der eingangs genannten Gattung so auszugestalten, dass ein als Stellglied dienender Aktor mit möglichst einfachen konstruktiven Mitteln und mit möglichst wenig Energieverbrauch zwischen mehreren stabilen Stellpositionen verstellt und in der jeweiligen Stellposition zurückgehalten werden kann. Die Aktoranordnung soll kostengünstig hergestellt werden können und lediglich einen geringen Raumbedarf aufweisen. Die Aktoranordnung soll zudem möglichst einfach miniaturisiert werden können.

Diese Aufgabe wird erfindungsgemäß dadurch gelöst, dass die erste Anlagefläche und die zweite Anlagefläche in dem ersten Verbindungsbereich des ersten Aktors in einer Versatzrichtung quer zu der ersten und zweiten Auslenkungsrichtung des zweiten Verformungsendes des zweiten Aktors versetzt zueinander angeordnet sind.

Als ein Eingriff im Sinne dieser Erfindung wird jeder Formschluss zwischen dem ersten Aktor und dem zweiten Aktor angesehen, der eine Auslenkung eines Verformungsendes eines Aktors in mindestens eine Auslenkungsrichtung begrenzt, so dass ein Anliegen eines Aktors an einer einzigen Anlagefläche, wodurch dessen Auslenkung in einer Auslenkungsrichtung begrenzt wird, ebenso als Eingriff angesehen wird wie das gleichzeitige Anliegen des Aktors an zwei Anlageflächen oder eine Anordnung eines Eingriffselements eines Aktors zwischen zwei Anlageflächen, wodurch eine Auslenkung des Aktors in zwei verschiedene Auslenkungsrichtungen begrenzt wird. Die erfindungsgemäße Aktoranordnung ermöglicht demzufolge mit einfachen konstruktiven Mitteln eine Aktoranordnung, mit der das zweite Verformungsende des zweiten Aktors längs der zugeordneten Verformungstrajektorie in zwei, drei oder mehr Auslenkungspositionen angeordnet und durch den ersten Aktor mit Hilfe eines formschlüssigen Eingriffs festgelegt werden kann. Die Verformungstrajektorie kann dabei im Wesentlichen linear verlaufen, so dass die verschiedenen stabilen Auslenkungspositionen längs einer Geraden angeordnet sind. Falls das Verformungsende des Verformungselements des zweiten Aktors längs einer näherungsweise bogenförmigen Verformungstrajektorie ausgelenkt wird, wie es beispielsweise bei unimorphen oder bimorphen Verformungselementen der Fall sein kann, sind die verschiedenen stabilen Auslenkungspositionen längs der bogenförmig verlaufenden Verformungstrajektorie angeordnet. Um einen zuverlässigen Eingriff des ersten Verformungsendes des ersten Aktors mit dem zweiten Verformungsende des zweiten Aktors zu bewirken ist in vorteilhafter Weise vorgesehen, dass sich die Verformungstrajektorie des ersten Aktors und die Verformungstrajektorie des zweiten Aktors unter einem positiven Winkel kreuzen.

Der erste Verbindungsbereich des ersten Aktors kann beispielsweise mehrere stufenförmige Vorsprünge oder Ausnehmungen aufweisen, die in der Versatzrichtung nebeneinander angeordnet sind. Der zweite Aktor muss einen daran angepassten zweiten Verbindungsbereich aufweisen, um einen Formschluss mit dem ersten Verbindungsbereich des ersten Aktors zu ermöglichen. Auf diese Weise kann ein Formschluss zwischen dem ersten Verformungsende des ersten Aktors und dem zweiten Verformungsende des zweiten Aktors nicht nur deren Position in einer ersten Auslenkungsrichtung, bzw. in der entgegengesetzten zweiten Auslenkungsrichtung vorgeben, sondern auch eine unbeabsichtigte Verlagerung oder Auslenkung der Verformungsenden der Aktoren quer dazu verhindern. Zudem kann auf diese Weise eine besonders flache und raumsparende Ausgestaltung der Aktoranordnung realisiert werden, da die Eingriffselemente, die für eine formschlüssige Festlegung des zweiten Verformungsendes des zweiten Aktors in einer mittleren Auslenkungsposition erforderlich sind, in einer quer zu dem Stellweg bzw. der Auslenkungsrichtung des als Stellglied dienenden zweiten Aktors angeordnet werden können.

Gemäß einer besonders vorteilhaften Ausgestaltung des Erfindungsgedankens ist vorgesehen, dass das zweite Verformungsende des zweiten Aktors in mindestens drei verschiedenen Auslenkungspositionen in dem ersten Verbindungsbereich mit dem ersten Verformungsende des ersten Aktors in Eingriff gebracht werden kann. Dadurch werden nicht nur zwei stabile Auslenkungspositionen für den zweiten Aktor ermöglicht, der als Stellglied der Aktoranordnung dient, sondern zusätzlich noch mindestens eine weitere dritte Auslenkungsposition, in welcher der zweite Aktor ebenfalls durch einen formschlüssigen Eingriff mit dem ersten Aktor festgelegt und fixiert werden kann. Durch die Ausgestaltung und Anordnung der beiden Anlageflächen wird zwischen den maximal ausgelenkten stabilen Auslenkungspositionen, nämlich den bei bistabilen Aktoranordnungen bereits möglichen Auslenkungspositionen eine zusätzliche dritte stabile Auslenkungsposition ermöglicht. Da durch die beiden Anlageflächen, die gleichzeitig beide Auslenkungsrichtungen des zweiten Verformungsendes des zweiten Aktors begrenzen, eine Auslenkung des zweiten Verformungselements aus der durch die Anlageflächen vorgegebenen Auslenkungsposition verhindert wird, sind keine zusätzlichen konstruktiven Maßnahmen oder Rückstellkräfte erforderlich, um das zweite Verformungsende in dieser zusätzlichen dritten Auslenkungsposition zurückzuhalten.

Die Verwendungsmöglichkeiten für eine derartige Aktoranordnung umfassen zahlreiche Anwendungsbereiche wie beispielsweise elektrische Relais oder optische Faserschalter. Eine erfindungsgemäße Aktoranordnung mit drei oder mehr stabilen Auslenkungspositionen des als Stellglied dienenden zweiten Aktors kann beispielsweise auch in taktilen Displays zur Darstellung von Braille-Schrift verwendet werden. Für jedes einzelne taktile Schaltelement kann eine Aktoranordnung eingesetzt werden. Zusätzlich zu den bereits mit bistabilen Aktoranordnungen möglichen zwei Schaltzuständen, mit denen üblicherweise eine fühlbare Auslenkungsposition des als Stellglied dienenden zweiten Aktors und eine nicht-fühlbare Auslenkungsposition ermöglicht werden, können mit der erfindungsgemäßen Aktoranordnung zusätzlich weitere Schaltzustände vorgegeben werden. Mit diesen zusätzlichen Schaltzuständen, bzw. Auslenkpositionen des zweiten Aktors kann beispielsweise eine erhöhte Informationsdichte zur Verfügung gestellt werden. Es ist ebenfalls denkbar, die einzelnen Aktoranordnungen beispielsweise während einer Nichtbenutzung des taktilen Displays in eine materialschonende Ruheposition zu verlagern. Nach einer vorausgehenden Kalibrierung können weiterhin herstellungsbedingte Fertigungstoleranzen ausgeglichen werden, indem durch eine Vorgabe der jeweils bestmöglich geeigneten Auslenkungsposition gleiche Informationen durch Schaltzustände der Aktoranordnungen mit einer möglichst gleichgroßen fühlbaren Tasthöhe für einen Benutzer dargestellt werden können.

Bei einer derartigen Aktoranordnung dient der erste Aktor als Sperrglied, mit dem der als Stellglied dienende zweite Aktor in verschiedenen Auslenkungspositionen durch einen geeigneten Formschluss festgelegt werden kann und eine weitere Auslenkung oder eine Rückstellbewegung des zweiten Aktors aus der vorgegebenen Auslenkungsposition durch das Sperrglied versperrt wird.

Es ist ebenfalls möglich, dass die erste Anlagefläche und die zweite Anlagefläche in dem ersten Verbindungsbereich des ersten Aktors in der ersten Auslenkungsrichtung beabstandet zueinander angeordnet sind. Wenn die beiden Anlageflächen in der Versatzrichtung quer zu der ersten und zweiten Auslenkungsrichtung versetzt, bzw. nebeneinander angeordnet sind, können beide Anlageflächen in der ersten Auslenkungsrichtung, bzw. in der zweiten Auslenkungsrichtung niveaugleich angeordnet sein. Sind die Anlageflächen dagegen in der ersten, bzw. zweiten Auslenkungsrichtung beabstandet zueinander angeordnet, können die erste Anlagefläche und die zweite Anlagefläche durch eine in der ersten Auslenkungsrichtung verlaufende geeignete Profilierung des ersten Verbindungsbereichs des ersten Aktors ausgebildet und dadurch kostengünstig hergestellt werden.

Vorzugsweise ist vorgesehen, dass in dem ersten Verbindungsbereich des ersten Aktors mindestens eine beidseitig begrenzte Ausnehmung ausgebildet ist, deren in der ersten Auslenkungsrichtung beabstandet zueinander angeordneten gegenüberliegenden Seitenrandflächen die erste Anlagefläche und die zweite Anlagefläche bilden, wodurch ein kammartig ausgestalteter erster Verbindungsbereich gebildet ist. Eine beidseitig begrenzte Ausnehmung kann beispielsweise eine nutenförmige Vertiefung sein. Eine derartige Vertiefung kann beispielsweise bei einer monolithischen Herstellung des ersten Verbindungsbereichs des ersten Aktors nachträglich ausgeformt oder ausgenommen werden. Auch eine monolithische Herstellung des Aktors oder des Verformungselements des Aktors im Spritzgussverfahren oder durch Druckverfahren ist denkbar, wobei die Vertiefung ohne nachträgliche Ausformung hergestellt werden kann. Es ist ebenfalls möglich, den ersten Verbindungsbereich des ersten Aktors aus mehreren Schichten herzustellen und schichtweise so zusammenzusetzen, dass zwischen zwei vorspringenden Schichten eine versetzt angeordnete, bzw. eine mit einem versetzt ausgebildeten Rand versehene Schicht angeordnet ist.

Es ist ebenfalls möglich, beide Varianten der Anordnung der beiden Anlageflächen miteinander zu kombinieren, so dass die erste Anlagefläche und die zweite Anlagefläche in dem ersten Verbindungsbereich des ersten Aktors sowohl in einer Versatzrichtung quer zu der ersten und zweiten Auslenkungsrichtung des zweiten Verformungsendes des zweiten Aktors versetzt zueinander als auch in der ersten Auslenkungsrichtung beabstandet zueinander angeordnet sind. Auf diese Weise können die einzelnen Anlageflächen beispielsweise matrixartig über den ersten Verbindungsbereich verteilt angeordnet sein, um komplexe Anordnungen von stabilen Auslenkungspositionen zu ermöglichen. Durch seitlich in Versatzrichtung versetzte Ausformungen, die eine Anlagefläche oder mehrere Anlageflächen bilden, kann zudem ein zusätzlicher Anschlag und dadurch bewirkter formschlüssiger Eingriff in Versatzrichtung gebildet werden.

Um bei einem möglichst geringen Raumbedarf weitere zusätzliche stabile Auslenkungspositionen des zweiten Verformungsendes des zweiten Aktors zu ermöglichen, ist erfindungsgemäß vorgesehen, dass in einem zweiten Verbindungsbereich an dem zweiten Verformungsende des zweiten Aktors mindestens eine beidseitig begrenzte Ausnehmung ausgebildet ist, deren in der ersten Auslenkungsrichtung beanstandet zueinander angeordneten gegenüberliegenden Seitenrandflächen eine erste Anlagefläche und eine zweite Anlagefläche bilden, so dass die Ausnehmungen und damit die Anlageflächen kammartig oder matrixartig über den zweiten Verbindungsbereich des zweiten Aktors verteilt sind. Die Ausnehmungen an dem zweiten Verformungsende des zweiten Aktors können auch durch vorspringende Ausformungen gebildet werden, zwischen denen sich die Ausnehmungen befinden. Die beidseitig begrenzten Ausnehmungen und die vorspringenden Ausformungen in dem zweiten Verbindungsbereich an dem zweiten Verformungsende des zweiten Aktors sind hinsichtlich der jeweiligen Abmessungen so ausgestaltet, dass das zweite Verformungsende in der ersten Auslenkungsrichtung, bzw. in der zweiten Auslenkungsrichtung in jeweils mehreren stabilen Auslenkungspositionen mit dem ersten Aktor in Eingriff gebracht werden und dadurch festgelegt werden kann.

In Abhängigkeit von der Ausgestaltung der Verformungselemente und den jeweiligen Verformungseigenschaften kann vorgesehen sein, dass der erste Verbindungsbereich des ersten Aktors und/oder der zweite Verbindungsbereich des zweiten Aktors zwei oder mehr als zwei beidseitig begrenzte Ausnehmungen aufweist. Auf diese Weise können eine Anzahl von stabilen Auslenkungspositionen ermöglicht werden, in denen das zweite Verformungsende des zweiten Aktors relativ zu dem ersten Verformungsende des ersten Aktors formschlüssig festgelegt und dauerhaft zurückgehalten werden kann, ohne dass für die Verweildauer des zweiten Verformungsendes des zweiten Aktors in der vorgegebenen Auslenkungsposition eine zusätzliche Energieaufnahme erforderlich ist. Damit können mit einfachen konstruktiven Mitteln Aktoranordnungen bereitgestellt werden, die beispielsweise drei, vier, fünf oder mehr verschiedene Auslenkungspositionen ermöglichen und die äußerst energieeffizient betrieben und genutzt werden können.

Anstelle von beidseitig begrenzten Ausnehmungen können auch beidseitig begrenzte vorspringende Ausformungen in dem ersten Verbindungsbereich bzw. in dem zweiten Verbindungsbereich vorgesehen sein, mit deren Hilfe ein formschlüssiger Eingriff ermöglicht wird. Die Anlageflächen müssen dabei längs oder quer zu der Verformungstrajektorie nicht notwendigerweise parallel zueinander ausgerichtet sein. Es sind beispielsweise auch spitze oder stumpfe Winkel zwischen den beiden Anlageflächen denkbar, um beispielsweise durch Hinterschneidungen eine zuverlässige Verrastung der beiden Aktoren zu bewirken, oder durch schräg angeordnete Anlageflächen einen Eingriff leichter herbeiführen und ein unerwünschtes Verkanten während des Betriebs zuverlässig ausschließen zu können.

Durch die formschlüssige Festlegung des zweiten Verformungsendes des zweiten Aktors in einer mittleren Auslenkungsposition, in welcher das zweite Verformungsende des zweiten Aktors sowohl in der ersten Auslenkungsrichtung als auch in der entgegengesetzten zweiten Auslenkungsrichtung formschlüssig festgelegt und versperrt ist, können diese mittleren Auslenkungspositionen in vorteilhafter Weise für eine materialschonende und eine mechanische Belastung der Aktoreinrichtung reduzierende Ausgestaltung einer Ruhe- bzw. Lagerungsposition der beiden Aktoren genutzt werden.

Die erste Verformungstrajektorie des ersten Verformungsendes des ersten Aktors und die zweite Verformungstrajektorie des zweiten Verformungsendes des zweiten Aktors können nicht ausschließlich parallel zueinander angeordnet sein, da in diesem Fall durch eine Verlagerung der beiden Aktoren innerhalb der jeweiligen Verformungsebene kein Eingriff des ersten Aktors und dem zweiten Aktor hergestellt oder gelöst werden kann. Es ist jedoch grundsätzlich möglich, dass die erste Verformungstrajektorie in einem Bereich um den Eingriffsbereich zwischen den beiden Aktoren einen spitzen, bzw. stumpfen Winkel relativ zu der zweiten Verformungstrajektorie aufweist und eine derartige Ausgestaltung kann vorteilhaft sein, um einen anwendungsbedingt oder bauartbedingt vorgegebenen Bauraum möglichst effizient ausnutzen zu können.

Gemäß einer besonders vorteilhaften Ausgestaltung des Erfindungsgedankens ist vorgesehen, dass aus einer stabilen Auslenkungsposition der beiden Aktoren heraus die erste Verformungstrajektorie des ersten Verformungsendes des ersten Aktors senkrecht zu der der zweiten Verformungstrajektorie des zweiten Verformungsendes des zweiten Aktors gerichtet ist. Auf diese Weise können die Auslenkungen der Verformungselemente der Aktoren gering sein, die notwendig sind, um einen Eingriff zwischen den beiden Aktoren herstellen oder lösen zu können. Zudem kann bei einer senkrechten Ausrichtung der Verformungstrajektorien zueinander trotz nahezu unbehinderter Verlagerungen zwischen einzelnen Auslenkungspositionen eine besonders hohe Sperrwirkung erzielt werden, die eine unbeabsichtigte Bewegung und Auslenkung der Aktoren verhindert.

Es ist ebenfalls denkbar, dass eine von dem ersten Befestigungsende zu dem ersten Verformungsende des ersten Aktors gerichtete erste Ausrichtung einen positiven Ausrichtungswinkel relativ zu einer von dem zweiten Befestigungsende zu dem zweiten Verformungsende des zweiten Aktors gerichtete zweite Ausrichtung aufweist. Die beiden Verformungselemente der beiden Aktoren müssen nicht notwendigerweise gleichgerichtet und nebeneinander angeordnet sein. Es ist ebenfalls möglich und für viele Anwendungsbereiche vorteilhaft, dass der Ausrichtungswinkel zwischen dem ersten Verformungselement des ersten Aktors und dem zweiten Verformungselement des zweiten Aktors näherungsweise ein rechter Winkel ist.

Gemäß einer besonders vorteilhaften Ausgestaltung des Erfindungsgedankens ist vorgesehen, dass der erste Aktor in einem unbetätigten Zustand eine Ruheposition einnimmt und in dieser Ruheposition mit dem zweiten Aktor in Eingriff ist, wobei der zweite Aktor in mindestens drei verschiedenen Auslenkungspositionen mit dem ersten Aktor in dessen Ruheposition in Eingriff bringbar ist. In der Ruheposition werden auf den ersten Aktor keine externen Kräfte oder Momente ausgeübt, sodass mit Ausnahme des Eingriffs mit dem zweiten Aktor keine nennenswerten Verspannungen oder Verformungen des ersten Verformungselements des ersten Aktors verursacht werden oder erfolgen. Der erste Aktor kann in dieser Ruheposition materialschonend und ohne größere mechanische Belastung über einen langen Zeitraum positioniert sein. Rückstellkräfte, die bei einer Auslenkung des ersten Verformungselements aus dessen Ruheposition auf das erste Verformungselement einwirken, führen dazu, dass der erste Aktor in dessen Ruheposition und damit in die Eingriffsposition mit dem zweiten Aktor zurückgeführt bzw. in dieser Ruheposition zurückgehalten wird, ohne dass hierfür zusätzliche konstruktive Maßnahmen oder eine externe Energiezufuhr erforderlich sind.

Es ist ebenfalls möglich, dass der erste Aktor in einem unbetätigten Zustand eine Ruheposition einnimmt und in dieser Ruheposition nicht mit dem zweiten Aktor in Eingriff ist. Auf diese Weise kann ein Fail-Safe-Modus bereitgestellt werden, bei dem die beiden Aktoren nicht in Eingriff stehen, falls keine externe Energie zugeführt wird, um beispielsweise die Aktoren vor einer unerwünschten Beschädigung zu schützen. Lohnenswert wäre eine derartige Ruheposition beispielsweise auch dann, wenn der zweite Aktor durch größere Abmessungen und größere Stellkräfte wesentlich mehr Energie zur Auslenkung benötigt.

Die erfindungsgemäße Aktoreinrichtung eignet sich in besonders vorteilhafter Weise für eine Miniaturisierung und deren Verwendung in kleinen und kleinsten technischen Systemen. Zu diesem Zweck ist vorgesehen, dass der erste Aktor und der zweite Aktor jeweils ein Mikroaktor ist. Bei einem Mikroaktor weisen die einzelnen stabilen Auslenkungspositionen weniger als 1 mm, vorzugsweise weniger als 100 µm Abstand zueinander auf. Die Abmessungen oder die Toleranzen der Abmessungen des ersten Verformungselements und des zweiten Verformungselements können beispielsweise kleiner als ein Millimeter und vorzugsweise in einem Bereich kleiner als 100 Mikrometer bis kleiner als 10 Mikrometer sein.

Für eine gewünschte Auslenkung des ersten Verformungselements und des zweiten Verformungselements können verschiedene Antriebe und Wirkprinzipien verwendet werden. Es ist beispielsweise denkbar, das erste Verformungselement oder das zweite Verformungselement mit einem Formgedächtnismaterial oder mit mindestens einem bistabilen Auslenkungselement zu versehen, um durch eine Aktivierung des betreffenden Verformungselements eine kontinuierliche oder diskontinuierliche Verlagerung und Auslenkung des jeweiligen Verformungsendes des Verformungselements zu erzwingen.

Einer vorteilhaften Ausgestaltung des Erfindungsgedankens zu Folge ist vorgesehen, dass das erste Verformungselement und/oder das zweite Verformungselement ein elektrothermisch verformbares Verformungselement ist. Durch eine elektrisch betätigbare Heizeinrichtung, beispielsweise durch einen an oder in dem Verformungselement verlegten Heizdraht, kann eine gezielte, üblicherweise bereichsweise Erwärmung des Verformungselements bewirkt und eine temperaturbedingte Ausdehnung zur gewünschten Auslenkung des Verformungsendes des Verformungselements ausgenutzt werden. Ein elektrothermisch verformbares Verformungselement kann kostengünstig miniaturisiert hergestellt werden, wobei beispielsweise aus der Halbleiterfabrikation bekannte Herstellungsverfahren zum Einsatz kommen können. Ein elektrothermisch verformbares Verformungselement weist zweckmäßigerweise zwei näherungsweise parallele Verformungsschenkel auf, die an den jeweils einander zugeordneten Enden miteinander verbunden sind. Bei einer Erwärmung eines der beiden Schenkel dehnt sich der betreffende Schenkel aus und wird durch die Anbindung an den parallel verlaufenden zweiten Schenkel zu einer seitlichen Auslenkung gezwungen. Es sind jedoch auch andere, ebenfalls geeignete Ausgestaltungen von elektrothermisch betätigbaren Verformungselementen bekannt und je nach Anwendungsfall geeignet.

Um eine möglichst kostengünstige und rasche Herstellung einer derartigen Aktoranordnung in großen Stückzahlen zu ermöglichen kann vorgesehen sein, dass das erste Verformungselement und/oder das zweite Verformungselement mehrschichtig ausgestaltet sind. Die einzelnen Schichten können dabei entweder gesondert voneinander hergestellt und in einem nachfolgenden Herstellungsschritt miteinander verbunden werden. Es ist ebenfalls möglich, die einzelnen Schichten nacheinander herzustellen und übereinander aufzutragen. Dabei können beispielsweise die aus der Halbleitertechnik bekannten Herstellungsverfahren vorteilhaft eingesetzt werden. Es sind jedoch auch andere Herstellungsverfahren wie beispielsweise Spritzgussverfahren denkbar und in Abhängigkeit von der Ausgestaltung der Aktoren vorteilhaft einsetzbar.

Es ist grundsätzlich möglich und für viele Anwendungsbereiche vorteilhaft, dass das erste Verformungselement und/oder das zweite Verformungselement teilweise oder vollständig aus einem Polymermaterial bestehen. Ein Polymermaterial kann vorteilhafte mechanische und thermische Eigenschaften aufweisen. Ein Polymermaterial kann darüber hinaus elektrisch isolierende Eigenschaften aufweisen, sodass eine derartige Aktoranordnung, die überwiegend oder vollständig aus einem derartigen Polymermaterial besteht, in elektrischen oder elektronischen Geräten und Systemen ohne größeren Aufwand problemlos eingesetzt und verwendet werden kann.

Nachfolgend werden beispielhaft einige Ausgestaltungen des Erfindungsgedankens erläutert, die in der Zeichnung exemplarisch dargestellt sind. Es zeigt:
Figur 1a bis 1d eine schematische Darstellung einer erfindungsgemäßen Aktoranordnung mit einem ersten Aktor und mit einem in einem rechten Winkel dazu ausgerichteten zweiten Aktor, wobei der zweite Aktor in drei stabilen Auslenkungspositionen mit dem ersten Aktor in Eingriff gebracht werden kann, wobei exemplarisch zwei verschiedene Eingriffspositionen in stabilen Auslenkungspositionen sowie dazwischen notwendige Verlagerungszustände der einzelnen Aktoren dargestellt sind,
Figur 2a bis 2f verschiedene Schnittansichten der in den Figuren 1 und 2 gezeigten Aktoreinrichtung längs einer Schnittlinie III-III in Figur 2, wobei schematisch die drei stabilen Auslenkungspositionen und verschiedene Auslenkungen der beiden Aktoren relativ zueinander gezeigt sind,
Figur 3 eine schematische Darstellung eines Herstellungsverfahrens, mit dem eine in den Figuren 1 und 2 gezeigte Aktoranordnung hergestellt werden kann,
Figur 4a bis 4h eine Anzahl von Schnittansichten durch eine Aktoranordnung mit einem ersten Aktor und mit einem zweiten Aktor, die einen ersten Verbindungsbereich und einen zweiten Verbindungsbereich aufweisen, der jeweils so ausgebildet ist, dass die beiden Aktoren in vier stabilen Auslenkungspositionen miteinander in Eingriff gebracht werden können,
Figur 5 eine exemplarische Ausgestaltung einer abweichend ausgestalteten Aktoranordnung in einer perspektivischen Ansicht,
Figur 6a bis 6e eine Anzahl von Schnittansichten längs der Linie VI-VI in Figur 5 durch die in Figur 5 gezeigte Aktoranordnung,
Figur 7 eine exemplarische Ausgestaltung einer abweichend ausgestalteten Aktoranordnung in einer perspektivischen Ansicht,
Figur 8a bis 8e eine Anzahl von Schnittansichten längs der Linie VIII-VIII in Figur 5 durch die in Figur 7 gezeigte Aktoranordnung,
Figur 9 eine exemplarische Ausgestaltung einer abweichend ausgestalteten Aktoranordnung in einer perspektivischen Ansicht,
Figur 10a bis 10e eine Anzahl von Schnittansichten längs der Linie X-X in Figur 5 durch die in Figur 9 gezeigte Aktoranordnung,
Figur 11 eine schematische Darstellung eines ersten Verformungselements eines ersten Aktors mit einer an einem Verformungsende ausgebildeten vorspringenden Ausformung, die zwei Anlageflächen bildet,
Figur 12a bis 12f eine Anzahl von exemplarischen und schematischen Schnittansichten längs der Linie XII-XII in Figur 11 von unterschiedlich ausgestalteten Querschnittsflächen der in Figur 11 gezeigten vorspringenden Ausformung, und
Figur 13a bis 13c eine Anzahl von exemplarischen und schematischen Schnittansichten längs der Linie XIII-XIII in Figur 11 von unterschiedlich ausgestalteten Querschnittsflächen der in Figur 11 gezeigten vorspringenden Ausformung.

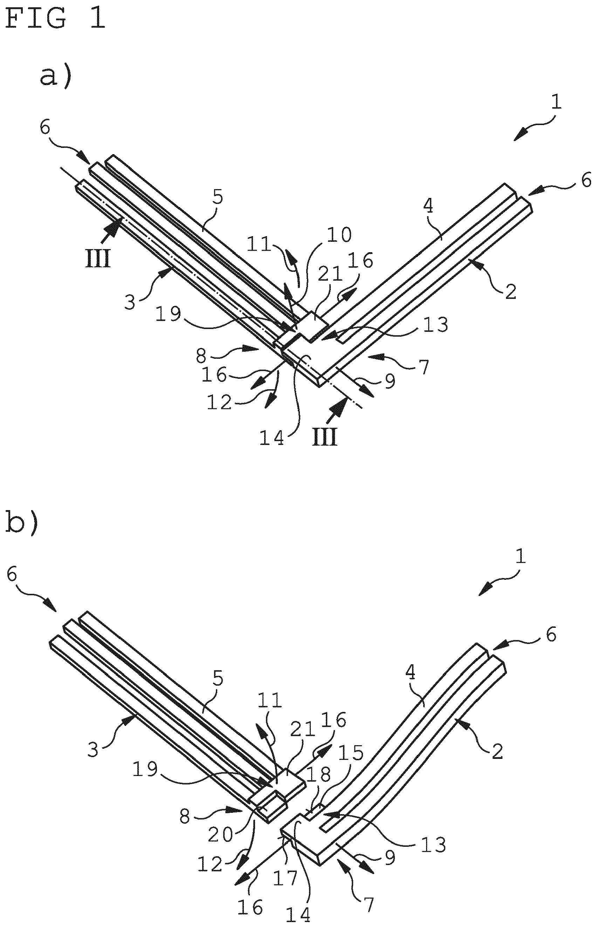

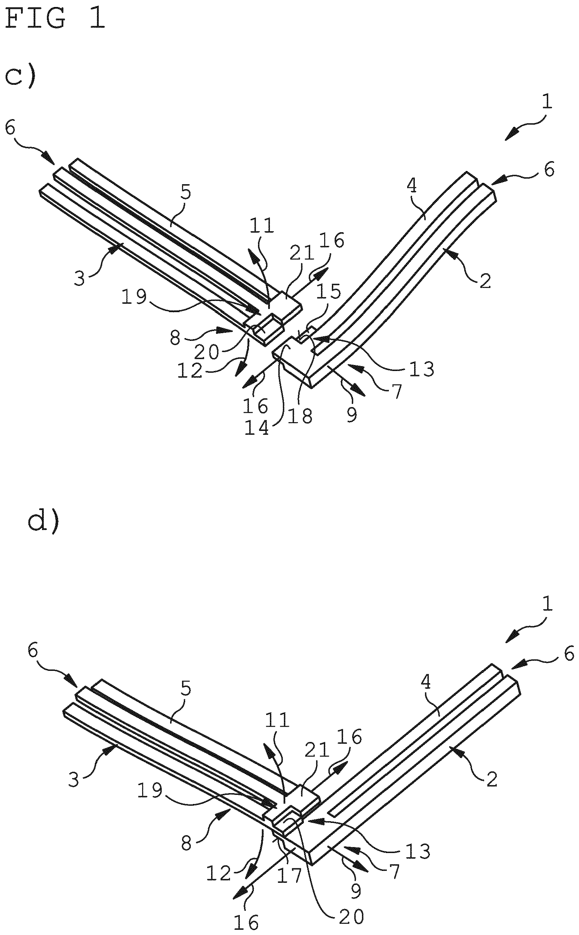

Eine in den Fig. 1 bis 3 exemplarisch dargestellte Aktoreinrichtung 1 weist einen ersten Aktor 2 und einen zweiten Aktor 3 auf. Jeder Aktor 2, 3 weist jeweils ein Verformungselement 4, 5 auf, dass an einem Befestigungsende 6 an einer nicht dargestellten Trägerstruktur festgelegt ist. Ein gegenüberliegendes Verformungsende 7, 8 der Verformungselemente 4, 5 kann jeweils durch eine in den Fig. 1 bis 3 nicht gesondert dargestellte elektrothermische Betätigungseinrichtung ausgelenkt werden. Durch eine geeignete Ausgestaltung der Verformungselemente 4, 5 und durch eine geeignete Anordnung und Betätigung der elektrothermischen Betätigungseinrichtungen kann bewirkt werden, dass das erste Verformungselement 4 des ersten Aktors 2 näherungsweise bogenförmig längs einer ersten Verformungstrajektorie in einer ersten Verformungsebene verformt und dadurch das erste Verformungsende 7 in der ersten Verformungsebene ausgelenkt werden kann. Der Beginn und die Richtung der ersten Verformungstrajektorie sind durch einen mit 9 bezeichneten Richtungsvektor angedeutet. Weiterhin kann bewirkt werden, dass das zweite Verformungselement 5 des zweiten Aktors 3 näherungsweise bogenförmig längs einer zweiten Verformungstrajektorie in einer zweiten Verformungsebene verformt und dadurch das zweite Verformungsende 8 des zweiten Verformungselements 5 in der zweiten Verformungsebene ausgelenkt werden kann. Der Beginn und die Richtung der zweiten Verformungstrajektorie ist durch einen mit 10 bezeichneten Richtungsvektor angedeutet. Die beiden Richtungsvektoren 9 und 10 der beiden Verformungstrajektorien der beiden Aktoren 2, 3 der Aktoreinrichtung 1 sind bei dem dargestellten Ausführungsbeispiel in einem rechten Winkel zueinander ausgerichtet. Das zweite Verformungsende 8 kann in einer ersten Auslenkungsrichtung 11, in den Fig. 1 bis 3 nach oben gerichtet, und in einer entgegengesetzten zweiten Auslenkungsrichtung 12, in den Fig. 1 bis 3 nach unten gerichtet, durch eine Betätigung der elektrothermischen Betätigungseinrichtung ausgelenkt werden.

Das erste Verformungsende 7 des ersten Verformungselements 4 des ersten Aktors 2 weist einen dem zweiten Aktor 3 zugewandten ersten Verbindungsbereich 13 auf. In dem ersten Verbindungsbereich 13 sind zwei stufenartig ausgestaltete in Richtung des zweiten Aktors 3 vorspringende Ausformungen 14, 15 ausgebildet, die in einer Versatzrichtung 16 quer zu der ersten und zweiten Auslenkungsrichtung 11, 12 des zweiten Aktors 3 überlappungsfrei versetzt angeordnet sind. An der ersten Ausformung 14 ist eine von unten zugängliche ebene erste Anlagefläche 17 ausgebildet. An der zweiten Ausformung 15 ist eine von oben zugängliche ebene zweite Anlagefläche 18 ausgebildet. Der zweite Aktor 3 weist einen hinsichtlich seiner Ausrichtung aus Ausgestaltung an den ersten Verbindungsbereich 13 des ersten Aktors 2 angepassten zweiten Verbindungsbereich 19 mit ebenfalls zwei vorspringenden Ausformungen 20, 21 auf. Der zweite Verbindungsbereich 18 des zweiten Aktors 3 kann mit dem ersten Verbindungsbereich 13 des ersten Aktors 2 in einer ersten stabilen Auslenkungsposition formschlüssig in Eingriff gebracht werden, wie es in Fig. 1a schematisch dargestellt ist. Durch eine Auslenkung des ersten Verformungsendes 7 des ersten Aktors 2 weg von dem zweiten Verformungsende 8 des zweiten Aktors 3 wird der Eingriff gelöst, was in Fig. 1b dargestellt ist. Das zweite Verformungsende 8 des zweiten Verformungselements 5 des zweiten Aktors 3 kann dann je nach Wunsch in die erste Auslenkungsrichtung 11 nach oben oder in die zweite Auslenkungsrichtung 12 nach unten ausgelenkt werden, bevor anschließend der erste Aktor 2 wieder zurückverlagert und in Eingriff mit dem zweiten Aktor 3 gebracht wird. In Fig. 1c ist exemplarisch eine Auslenkung des zweiten Verformungsendes 8 des zweiten Aktors 3 nach oben in Richtung 11 dargestellt, wobei der erste Aktor 2 weiterhin ausgelenkt bleibt. Anschließend wird der erste Aktor 2 in seine Ausgangsposition zurückverformt, so dass das erste Verformungsende 7 des ersten Aktors 2 unter dem zweiten Aktor 3 angeordnet ist und eine stabile Auslenkungsposition für den auf dem ersten Aktor 2 aufliegenden zweiten Aktor 3 vorgibt, wie es in Fig. 1d gezeigt ist.

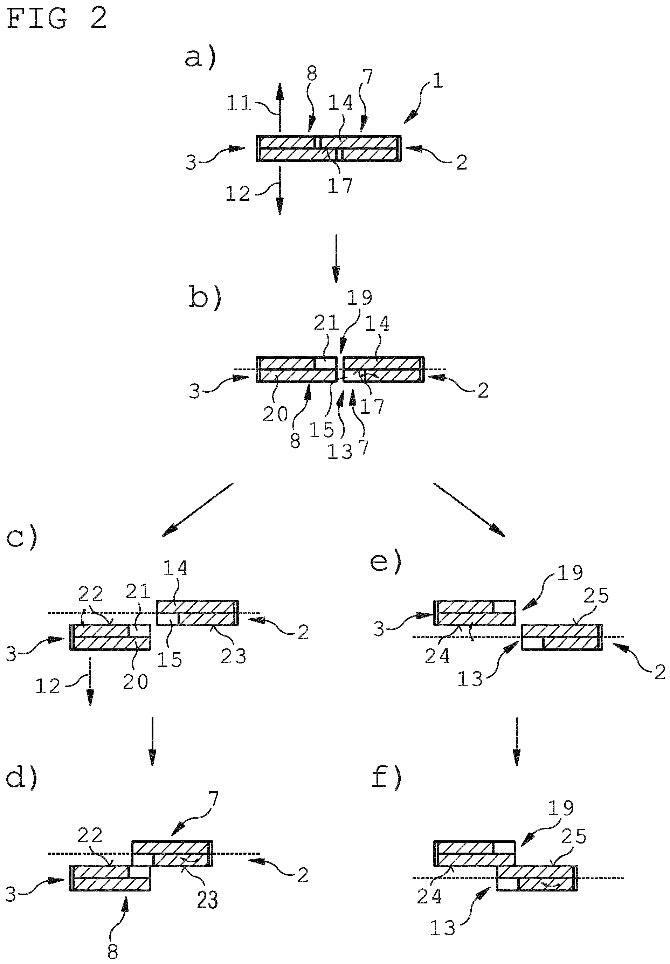

In Fig. 2 sind beispielhaft einige Anordnungen der Verformungsenden 7, 8 der beiden Aktoren 2, 3 während verschiedener Schaltzustände in einer Schnittansicht dargestellt. Der in Fig. 2a gezeigte Schaltzustand entspricht einer Anordnung des zweiten Verformungsendes 8 in einer mittleren stabilen Auslenkungsposition, die auch in Fig. 1a dargestellt ist, bei der der zweite Aktor 3 mit dem ersten Aktor 2 in Eingriff ist. In Fig. 2b wird exemplarisch eine Verlagerung des ersten Verformungsendes 7 des ersten Aktors 2 aus dem Eingriff mit dem zweiten Aktor 3 in dessen mittleren stabilen Auslenkungsposition heraus gezeigt, wie sie auch in Fig. 1b dargestellt ist. In diesen Schnittansichten kann der erste Aktor 2 nur in einer horizontalen Richtung verlagert werden, während der zweite Aktor 3 in einer ersten Auslenkungsrichtung 11 nach oben oder in einer zweiten Auslenkungsrichtung 12 nach unten, jedoch nicht in einer horizontalen Richtung verlagert werden kann.

Um das zweite Verformungsende 8 des zweiten Aktors 3 in eine untere stabile Auslenkungsposition zu bringen wird das zweite Verformungsende 8 nach unten verlagert, bis eine Oberseite 22 des zweiten Aktors 3 unterhalb einer Unterseite 23 des ersten Aktors 2 ist (Fig. 2c). Für diese Auslenkung muss die elektrothermische Betätigungseinrichtung des zweiten Aktors 3 aktiviert und Energie aufgebracht werden. Anschließend wird der erste Aktor 2 wieder freigegeben und zurück in dessen Ruheposition verlagert, um anschließend auch den zweiten Aktor 3 wieder freizugeben, so dass das zweite Verformungsende 8 des zweiten Aktors 3 an der Unterseite 22 des ersten Aktors 2 anliegt und der zweite Aktor 3 in einer dadurch vorgegebenen unteren stabilen Auslenkungsposition zurückgehalten wird (Fig. 2d). In analoger Weise kann der zweite Aktor 3 nach dessen Freigabe durch den seitlich ausgelenkten Aktor 2 nach oben ausgelenkt und nach einem erneuten Eingriff mit dem ersten Aktor 2 eine Unterseite 24 des zweiten Aktors 3 auf einer Oberseite 25 des ersten Aktors 2 aufliegen, so dass das zweite Verformungsende 8 des zweiten Aktors 3 in einer dadurch vorgegebenen oberen stabilen Auslenkungsposition zurückgehalten wird (Fig. 2e und 2f) .

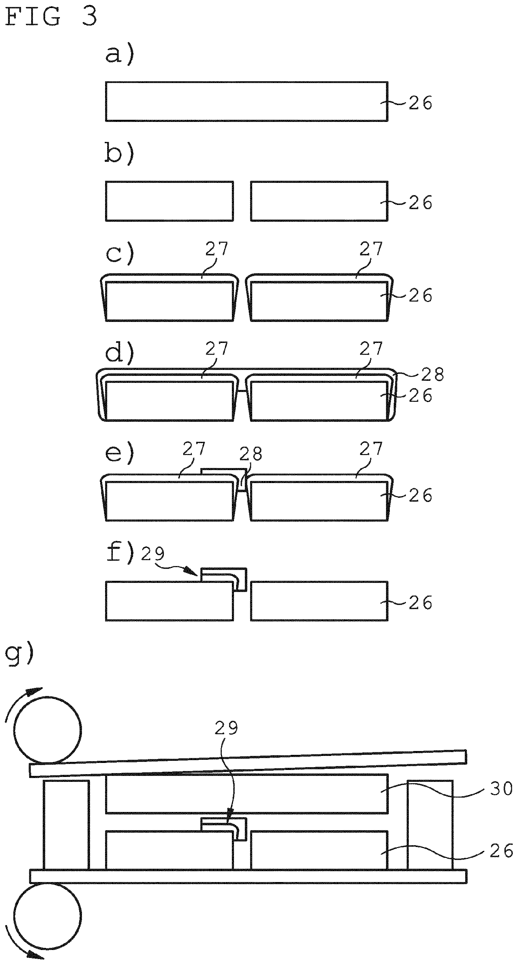

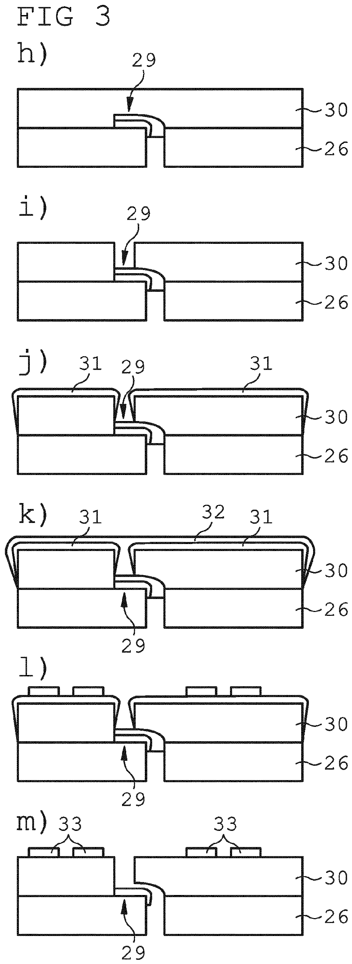

In Fig. 3 wird schematisch ein exemplarisch dargestelltes Herstellungsverfahren für eine Aktoranordnung 1 mit jeweils zweischichtigen Aktoren 2, 3 gezeigt, wie der in dem Ausführungsbeispiel gemäß den Fig. 1 und 3 verwendet ist. In Fig. 3 ist zur Veranschaulichung jeweils lediglich ein die beiden Verbindungsbereiche 13, 19 der beiden Aktoren 2, 3 umfassender Ausschnitt abgebildet.

Eine erste Schicht 26 (A) eines polymeren Substrats (Fig. 3a) wird durch eine geeignete Behandlung mittels UV-Lithografie und einem Fotolack (PGMEA) strukturiert (Fig. 3b). Anschließend wird die erste Schicht 26 mit einer Metallbeschichtung 27 versehen (Fig. 3c) und durch eine Sprühbelackung mit einem Photoresistmaterial 28 überzogen (Fig. 3d). Durch eine erneute Strukturierung des Photoresistmaterials 28 wird eine Ätzmaske erstellt (Fig. 3e), mit deren Hilfe nach einem Ätzvorgang im Bereich der formschlüssigen Überlappung der beiden Verformungsenden 7, 8 eine metallische und polymere Opferschichtstruktur 29 gebildet wird (Fig. 3f). Auf diese erste Schicht 26 mit der darauf ausgebildeten Oberschichtstruktur 29 wird eine zweite Schicht 30 (B) eines polymeren Substrats auflaminiert (Fig. 3g), so dass sich ein zweischichtiger Verbund ergibt (Fig. 3h). Auch die zweite Schicht 30 wird durch eine geeignete Behandlung mittels UV-Lithografie und mit einem Fotolack strukturiert (Fig. 3i) und ebenfalls mit einer Metallbeschichtung 31 (Fig. 3j) und anschließend mit einer Sprühbelackung mit einem Photoresistmaterial 32 überzogen (Fig. 3k). Nach einer geeigneten Strukturierung der Sprühbelackung (Fig. 3l) und einer dadurch bewirkten Erzeugung einer weiteren Ätzmaske können die metallischen Heizelemente 33 ausgebildet und zusätzlich die vorab erzeugte polymere Opferschicht entfernt werden (Fig. 3m). Auf diese Weise können mit aus der Halbleitertechnik bekannten Verfahrensschritten die beiden Aktoren 2, 3 zusammen mit Heizelementen 33 hergestellt werden, die jeweils Bestandteil einer elektrothermischen Betätigungseinrichtung sind.

Neben den vorangehend beschriebenen Verfahrensschritten und Herstellungsmethoden sind zahlreiche weitere Verfahren zur Herstellung einer derartigen Aktoreinrichtung 1 denkbar, beispielsweise feinmechanische strukturbildende Verfahren wie Fräsen, Laserschneiden oder Heißprägen von polymeren Materialien, aber auch beispielsweise Spritzgussverfahren, generative Fertigungsverfahren oder Beschichtungen mit Folien etc. Zur Erzeugung der Verformungsenden 7, 8 können neben polymeren Opferschichten auch Opferschichten aus anderen Materialien wie beispielsweise Metallen, Keramiken oder Halbleitermaterialien verwendet werden.

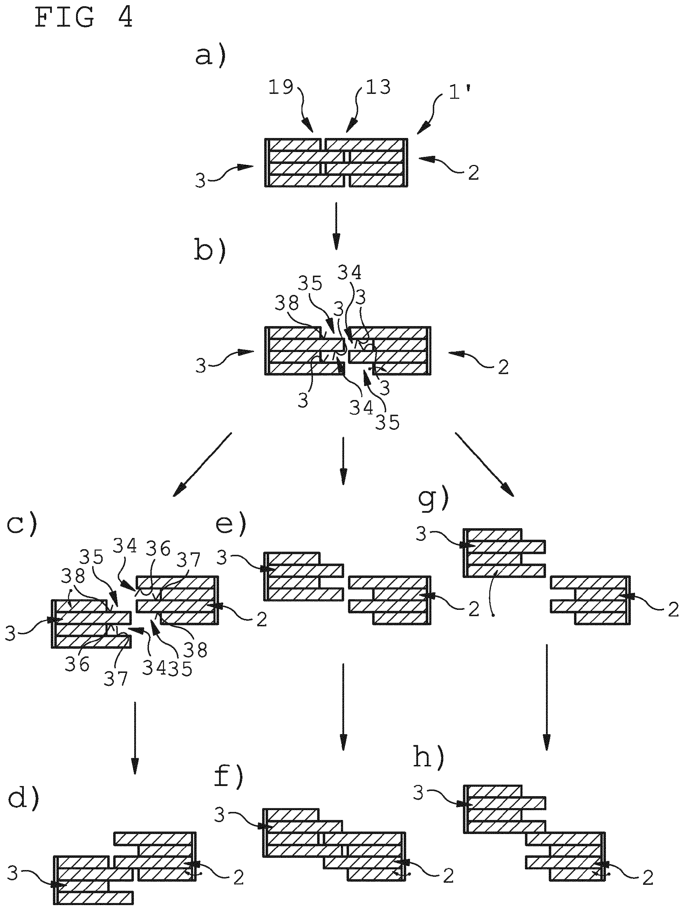

Bei dem in den Fig. 4a bis 4h schematisch dargestellten Ausführungsbeispiel einer abweichend ausgestalteten Aktoranordnung 1' weisen der erste Aktor 2 und der zweite Aktor 3 jeweils einen ersten, bzw. zweiten Verbindungsbereich 13, 19 auf, in welchem jeweils zwei Ausnehmungen 34, 35 ausgebildet sind. Die jeweils erste Ausnehmung 34 ist beidseitig begrenzt, so dass an den jeweiligen Seitenrandflächen eine erste Anlagefläche 36 und eine zweite Anlagefläche 37 ausgebildet sind. Die jeweils zweite Ausnehmung 35 ist von jeweils einer Seite aus frei zugänglich und bildet lediglich eine weitere dritte Anlagefläche 38.

Mit einer derartig ausgestalteten Aktoranordnung 1' können neben einer ersten mittleren stabilen Auslenkungsposition (Fig. 4a), in welcher sich sowohl der erste Aktor 2 als auch der zweite Aktor 3 in einer kräftefreien Ruheposition befinden, drei weitere stabile Auslenkungspositionen eingestellt werden. Nach einer Verlagerung des ersten Aktors 2, bis kein Eingriff mehr mit dem zweiten Aktor 3 besteht (Fig. 4b), kann das zweite Verformungsende 8 des zweiten Aktors 3 nach unten ausgelenkt (Fig. 4c) und nach einem erneuten Eingriff mit dem zurückverlagerten ersten Aktor 2 in eine untere stabile Auslenkungsposition gebracht werden (Fig. 4d). Der zweite Aktor 3 kann aber auch in eine obere mittlere stabile Auslenkungsposition (Fig. 4f) oder in eine obere stabile Auslenkungsposition (Fig. 4h) gebracht werden.

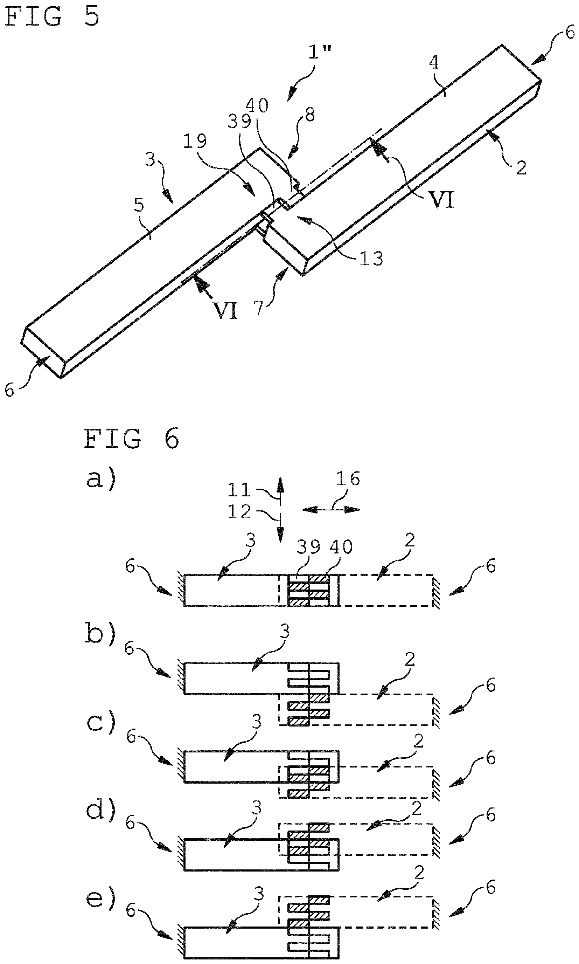

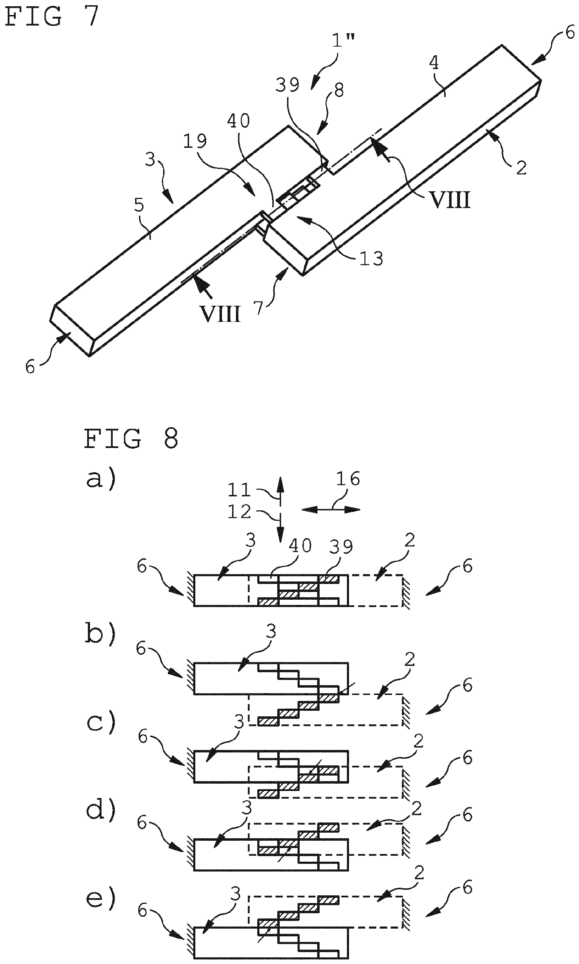

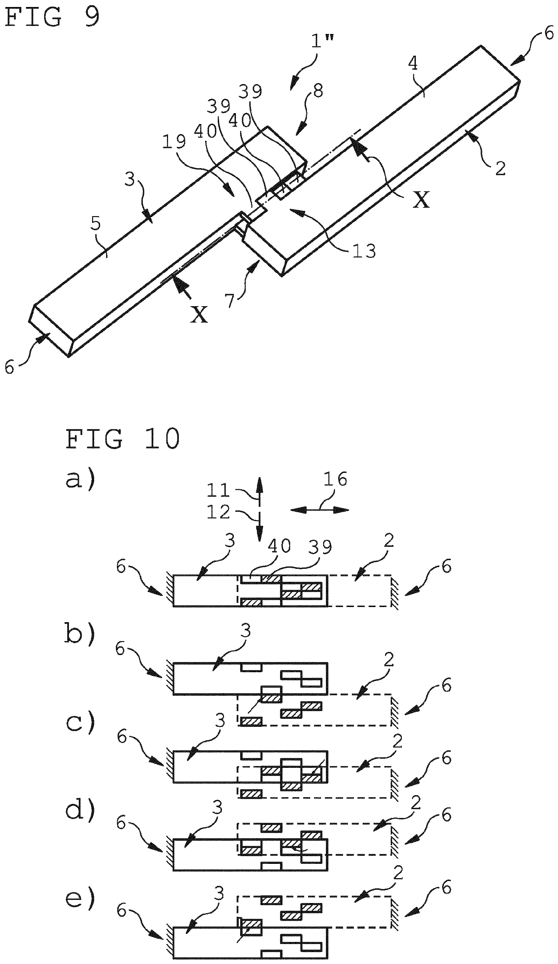

In den Figuren 5 bis 10 sind exemplarisch verschiedene Ausgestaltungen jeweils unterschiedlicher Aktoranordnungen 1" dargestellt, wobei in den Fig. 5, 7 und 9 jeweils eine perspektivische Ansicht der betreffenden Aktoranordnung 1" und in den Fig. 6, 8 und 10 jeweils zugeordnete Schnittansichten der miteinander in Eingriff stehenden Verbindungsbereiche 13, 19 abgebildet sind. Die an dem ersten Verformungsende 7 des ersten Aktors 2 ausgebildeten Ausformungen 39 sind in den Schnittansichten gemäß Figur 6 jeweils hell dargestellt, während die an dem zweiten Verformungsende 8 des zweiten Aktors 3 ausgebildeten Ausformungen 40 in den Schnittansichten jeweils dunkel dargestellt sind. In den Schnittansichten gemäß Figur 8 und gemäß Figur 10 sind die Ausformungen 39 des ersten Aktors 2 dunkel und die Ausformungen 40 des zweiten Aktors 3 hell dargestellt. Die Figuren 6a bis 6e, 8a bis 8e und 10a bis 10e zeigen jeweils fünf verschiedene mögliche stabile Auslenkungspositionen der betreffenden Aktoreinrichtung 1".

In den Figuren 5 und 6 ist exemplarisch ein Ausführungsbeispiel dargestellt, bei dem die jeweiligen Ausformungen 39 und 40 in zwei Reihen parallel nebeneinander kammartig übereinander angeordnet sind.

In den Figuren 7 und 8 ist exemplarisch ein Ausführungsbeispiel dargestellt, bei dem die jeweiligen Ausformungen 39 und 40 treppenartig seitlich versetzt und aufsteigend, bzw. absteigend angeordnet sind.

In den Figuren 9 und 10 ist exemplarisch ein Ausführungsbeispiel dargestellt, bei dem die jeweiligen Ausformungen 39 und 40 matrixförmig über den jeweiligen Verbindungsbereich 13 und 19 verteilt angeordnet sind.

Durch sowohl einen seitlichen Versatz in Versatzrichtung 16 als auch einen Abstand in den Verformungsrichtungen 11 und 12 des zweiten Aktors 3 können sowohl verschiedene stabile Auslenkungspositionen des zweiten Aktors 3 als auch ein zusätzlicher stabilisierender Eingriff in Versatzrichtung 16 ermöglicht werden.

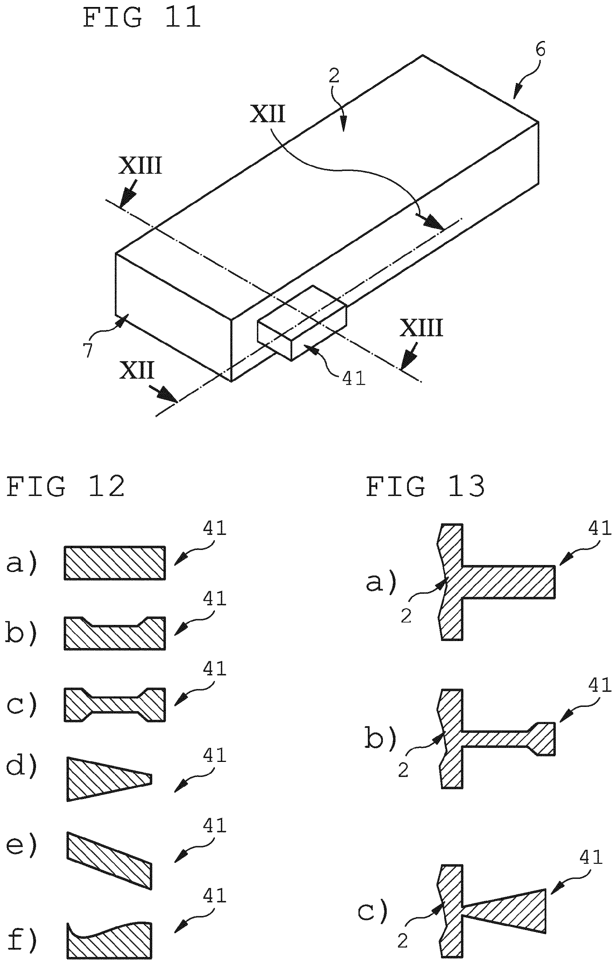

In den Figuren 11 bis 13 sind exemplarisch am Beispiel einer Ausformung 41 eines ersten Aktors 2 verschiedene jeweils mögliche Ausgestaltungen einer einzelnen Ausformung 14, 15, 20, 21, 39 und 40 der in den vorausgegangenen Ausführungsbeispielen der Aktoreinrichtungen 1, 1'und 1" dargestellt.

Die Ausformung 41 kann nicht nur eine rechteckige Querschnittsfläche aufweisen, wie es in den Schnittansichten der Figuren 12a und 13a dargestellt ist. Es ist ebenfalls möglich, dass die in Versatzrichtung 16 gerichteten Querschnittsflächen (Figur 12a bis 12f) sowohl bei der oberen Anlagefläche als auch bei der unteren Anlagefläche jeweils wahlweise und unabhängig voneinander eine von einer in Versatzrichtung 16 ausgerichteten Ebene abweichende Ausrichtung und Formgebung aufweisen können. Die mit diesen Ausformungen 41 in einer stabilen Auslenkungsposition des zweiten Aktors 3 in Eingriff bringbaren Ausformungen des zweiten Aktors 3 müssen eine daran angepasste, jedoch nicht notwendigerweise über die gesamte Anlagefläche vollständig anliegende Flächenkontur aufweisen.

Es ist ebenfalls möglich, mit zunehmendem Abstand der Ausformung 41 von dem Verformungsende 7, 8 des betreffenden Aktors 2, 3 eine Dicke der Ausformung 41 zu verändern. Auf diese Weise können beispielsweise Rastelemente oder Hinterschneidungen ausgebildet werden, mit denen ein Eingriff der beiden Verformungsenden 7, 8 in einer stabilen Auslenkungsposition zusätzlich verstärkt und beispielsweise gegenüber Erschütterungen gesichert werden kann. In den Figuren 13b und 13c sind exemplarisch entsprechende Ausgestaltungen der Ausformung 41 dargestellt.

## Patentansprüche

1. Aktoranordnung (1, 1', 1") mit einem ersten Aktor (2) und mit einem zweiten Aktor (3), wobei der erste Aktor (2) und der zweite Aktor (3) jeweils ein Verformungselement (4, 5) aufweisen, welches jeweils an einem Befestigungsende (6) festgelegt ist und jeweils ein dem Befestigungsende (6) gegenüberliegendes Verformungsende (7, 8) aufweist, das durch Verformung des Verformungselements (4, 5) relativ zu dem Befestigungsende (6) in einer Verformungstrajektorie ausgelenkt werden kann, wobei das erste Verformungsende (7) des ersten Aktors (2) durch Verformung des Verformungselements (4) mit dem zweiten Verformungsende (8) des zweiten Aktors (3) in Eingriff gebracht oder von dem zweiten Verformungsende (8) des zweiten Aktors (3) gelöst werden kann, so dass das zweite Verformungsende (8) des zweiten Aktors (3) auf dem ersten Verformungsende (7) des ersten Aktors (2) aufliegt oder das erste Verformungsende (7) des ersten Aktors (2) auf dem zweiten Verformungsende (8) des zweiten Aktors (3) aufliegt und dadurch zwei stabile Auslenkungspositionen des zweiten Aktors (3) vorgegeben werden, das erste Verformungsende (7) des ersten Aktors (2) einen ersten Verbindungsbereich (13) mit mindestens einer ersten Anlagefläche (17, 36), die eine Auslenkung des zweiten Verformungsendes (8) des zweiten Aktors (3) in einer ersten Auslenkungsrichtung (11) begrenzt, und mit mindestens einer zweiten Anlagefläche (18, 37) aufweist, die eine Auslenkung des zweiten Verformungsendes (8) des zweiten Aktors (3) in einer zweiten Auslenkungsrichtung (12) begrenzt, die der ersten Auslenkungsrichtung (11) entgegengesetzt ist, wenn das zweite Verformungsende (8) des zweiten Aktors (3) mit dem ersten Verformungsende (7) des ersten Aktors (2) in Eingriff ist und dabei das zweite Verformungsende (8) des zweiten Aktors (3) an der ersten Anlagefläche (17, 36) des ersten Aktors (2) anliegt, so dass in mindestens einer Auslenkungsposition des zweiten Aktors (3) durch die erste Anlagefläche (17, 36) und die zweite Anlagefläche (18, 37) des ersten Aktors (2) eine Auslenkung des zweiten Verformungsendes (8) des zweiten Aktors (3) gleichzeitig in der ersten Auslenkungsrichtung (11) und in der zweiten Auslenkungsrichtung (12) begrenzt ist, so dass das zweite Verformungsende (8) des zweiten Aktors (3) in mehreren Auslenkungspositionen in dem ersten Verbindungsbereich (13) mit dem ersten Verformungsende (7) des ersten Aktors (2) in Eingriff gebracht werden kann, **dadurch gekennzeichnet, dass** die erste Anlagefläche (17, 36) und die zweite Anlagefläche (18, 37) in dem ersten Verbindungsbereich (13) des ersten Aktors (2) in einer Versatzrichtung (16) quer zu der ersten und zweiten Auslenkungsrichtung (11, 12) des zweiten Verformungsendes (8) des zweiten Aktors (3) versetzt zueinander angeordnet sind..

2. Aktoreinrichtung (1, 1', 1") nach Anspruch 1, **dadurch gekennzeichnet, dass** das zweite Verformungsende (8) des zweiten Aktors (3) in mindestens drei verschiedenen Auslenkungspositionen in dem ersten Verbindungsbereich (13) mit dem ersten Verformungsende (7) des ersten Aktors (2) in Eingriff gebracht werden kann.

3. Aktoreinrichtung (1, 1', 1") nach einem der vorausgehenden Ansprüche, **dadurch gekennzeichnet, dass** die erste Anlagefläche (17, 36) und die zweite Anlagefläche (18, 37) in dem ersten Verbindungsbereich (13) des ersten Aktors (2) in der ersten Auslenkungsrichtung (11) beabstandet zueinander angeordnet sind.

4. Aktoreinrichtung (1, 1', 1") nach einem der vorausgehenden Ansprüche, **dadurch gekennzeichnet, dass** die erste Anlagefläche (17, 36) und die zweite Anlagefläche (18, 37) in dem ersten Verbindungsbereich (13) des ersten Aktors (2) sowohl in einer Versatzrichtung (16) quer zu der ersten und zweiten Auslenkungsrichtung (11, 12) des zweiten Verformungsendes (8) des zweiten Aktors (3) versetzt zueinander als auch in der ersten Auslenkungsrichtung (11) beabstandet zueinander angeordnet sind.

5. Aktoreinrichtung (1, 1', 1") nach einem der vorausgehenden Ansprüche, **dadurch gekennzeichnet, dass** in dem ersten Verbindungsbereich (13) des ersten Aktors (2) mindestens eine beidseitig begrenzte Ausnehmung (34) ausgebildet ist, deren in der ersten Auslenkungsrichtung (11) beabstandet zueinander angeordneten gegenüberliegenden Seitenrandflächen die erste Anlagefläche (36) und die zweite Anlagefläche (37) bilden, wodurch ein kammartig ausgestalteter erster Verbindungsbereich (13) gebildet ist.

6. Aktoreinrichtung (1, 1', 1") nach einem der vorausgehenden Ansprüche, **dadurch gekennzeichnet, dass** in einem zweiten Verbindungsbereich (19) an dem zweiten Verformungsende (8) des zweiten Aktors (3) mindestens eine beidseitig begrenzte Ausnehmung (34) ausgebildet ist, deren in der ersten Auslenkungsrichtung (11) beabstandet zueinander angeordneten gegenüberliegenden Seitenrandflächen eine erste Anlagefläche (36) und eine zweite Anlagefläche (37) bilden, wodurch ein kammartig ausgestalteter zweiter Verbindungsbereich (19) des zweiten Aktors (2) gebildet ist.

7. Aktoranordnung (1, 1', 1") nach Anspruch 6 oder Anspruch 7, **dadurch gekennzeichnet, dass** der erste Verbindungsbereich (13) des ersten Aktors (2) und/oder der zweite Verbindungsbereich (19) des zweiten Aktors (3) zwei oder mehr als zwei beidseitig begrenzte Ausnehmungen (34) aufweist.

8. Aktoranordnung (1, 1', 1") nach einem der vorausgehenden Ansprüche, **dadurch gekennzeichnet, dass** das erste Verformungselement (4) und/oder das zweite Verformungselement (5) ein elektrothermisch verformbares Verformungselement (4, 5) ist.

9. Aktoranordnung (1, 1', 1") nach einem der vorausgehenden Ansprüche, **dadurch gekennzeichnet, dass** an oder in dem ersten Verformungselement (4) des ersten Aktors (2) und/oder an oder in dem zweiten Verformungselement (5) des zweiten Aktors (3) jeweils ein Heizelement (33) angeordnet ist.

10. Aktoranordnung (1, 1', 1") nach einem der vorausgehenden Ansprüche, **dadurch gekennzeichnet, dass** aus einer stabilen Auslenkungsposition der beiden Aktoren (2, 3) heraus die erste Verformungstrajektorie senkrecht zu der der zweiten Verformungstrajektorie gerichtet ist.

11. Aktoranordnung (1, 1', 1") nach einem der vorausgehenden Ansprüche, **dadurch gekennzeichnet, dass** eine von dem ersten Befestigungsende (6) zu dem ersten Verformungsende (7) des ersten Aktors (2) gerichtete erste Ausrichtung einen positiven Ausrichtungswinkel relativ zu einer von dem zweiten Befestigungsende (6) zu dem zweiten Verformungsende (8) des zweiten Aktors (3) gerichtete zweite Ausrichtung aufweist.

12. Aktoranordnung (1, 1', 1") nach einem der vorausgehenden Ansprüche, **dadurch gekennzeichnet, dass** der erste Aktor (2) in einem unbetätigten Zustand eine Ruheposition einnimmt und in dieser Ruheposition mit dem zweiten Aktor (3) in Eingriff ist, wobei der zweite Aktor (3) in mindestens drei verschiedenen Positionen mit dem ersten Aktor (2) in dessen Ruheposition in Eingriff bringbar ist.

13. Aktoranordnung (1, 1', 1") nach einem der vorangehenden Ansprüche, **dadurch gekennzeichnet, dass** der erste Aktor (2) und der zweite Aktor (3) jeweils ein Mikroaktor ist.

14. Aktoranordnung (1, 1', 1") nach einem der vorausgehenden Ansprüche, **dadurch gekennzeichnet, dass** das erste Verformungselement (4) und/oder das zweite Verformungselement (5) mehrschichtig ausgestaltet sind.

15. Aktoranordnung (1, 1', 1") nach einem der vorausgehenden Ansprüche, **dadurch gekennzeichnet, dass** das erste Verformungselement (4) und/oder das zweite Verformungselement (5) teilweise oder vollständig aus einem Polymermaterial bestehen.

## Claims

1. Actuator arrangement (1, 1', 1") with an first actuator (2) and with a second actuator (3), wherein the first actuator (2) and the second actuator (3) respectively comprise a deformation element (4, 5), which is respectively secured on a fastening end (6) and respectively comprises a deformation end (7, 8) located opposite the fastening end (6), which deformation end can be deflected in a deformation trajectory by the deformation of the deformation element (4, 5) relative to the fastening end (6), wherein the first deformation end (7) of the first actuator (2) can be brought into engagement with the second deformation end (8) of the second actuator (3), or can be released from the second deformation end (8) of the second actuator (3), so that the second deformation end (8) of the second actuator (3) rests on the first deformation end (7) of the first actuator (2), or the first deformation end (7) of the first actuator (2) rests on the second deformation end (8) of the second actuator (3), and two stable deflection positions of the second actuator (3) are defined thereby, the first deformation end (7) of the first actuator (2) comprises a first connection area (13) with at least a first contact surface (17, 36) that limits a deflection of the second deformation end (8) of the second actuator (3) in a first deflection direction (11), and with at least a second contact surface (18, 37), which limits a deflection of the second deformation end (8) of the second actuator (3) in a second deflection direction (12), which is opposite the first deflection direction (11), when the second deformation end (8) of the second actuator (3) is in engagement with the first deformation end (7) of the first actuator (2) and the second deformation end (8) of the second actuator (3) rests against the first contact surface (17, 36) of the first actuator (2), so that in at least one deflection position of the second actuator (3), a deflection of the second deformation end (8) of the second actuator (3) is limited in the first deflection direction (11) as well as in the second deflection direction (12) at the same time by the first contact surface (17, 36) and the second contact surface (18, 37) of the first actuator (2), so that the second deformation end (8) of the second actuator (3) in multiple deflection positions in the first connection area (13) can be brought in engagement with the first deformation end (7) of the first actuator (2), **characterized in that** the first contact surface (17, 36) and the second contact surface (18, 37), in the first connection area (13) of the first actuator (2), are arranged offset to one another transversally to the first and second deflection directions (11, 12) of the second deformation end (8) of the second actuator (3).

2. Actuator arrangement (1, 1', 1") according to claim 1, **characterized in that** the second deformation end (8) of the second actuator (3) can be brought in engagement with the first deformation end (7) of the first actuator (2) in at least three different deflection positions in the first connection area (13).

3. Actuator arrangement (1, 1', 1") according to any one of the preceding claims, **characterized in that** the first contact surface (17, 36) and the second contact surface (18, 37) in the first connection area (13) of the first actuator (2) are arranged spaced from one another in the first deflection direction (11).

4. Actuator arrangement (1, 1', 1") according to any one of the preceding claims, **characterized in that** the first contact surface (17, 36) and the second contact surface (18, 37) in the first connection area (13) of the first actuator (2) are arranged offset to one another in an offset direction (16) transversally to the first and second deflection direction (11, 12) of the second deformation end (8) of the second actuator (3) and as well are arranged spaced from one another in the first deflection direction (11).

5. Actuator arrangement (1, 1', 1") according to any one of the preceding claims, **characterized in that** at least one recess (34) delimited on both sides is formed in the first connection area (13) of the first actuator (2), the lateral edge surfaces of which recess, which are arranged oppositely and spaced from one another in the first deflection direction (11), form the first contact surface (36) and the second contact surface (37), whereby a first connection area (13) of comb-like design is formed.

6. Actuator arrangement (1, 1', 1") according to any one of the preceding claims, **characterized in that** in a second connection area (19) on the second deformation end (8) of the second actuator (3), at least one recess (34) is formed, which is delimited on both sides, the lateral edge surfaces of which recess, which are arranged oppositely and spaced from one another in the first deflection direction (11), form a first contact surface (36) and a second contact surface (37), whereby a second connection area (19) of comb-like design of the second actuator (2) is formed.

7. Actuator arrangement (1, 1', 1") according to claim 6 or 7, **characterized in that** the first connection area (13) of the first actuator (2) and/or the second connection area (19) of the second actuator (3) comprises two or more than two recesses (34) which are delimited on both sides.

8. Actuator arrangement (1, 1', 1") according to any one of the preceding claims, **characterized in that** the first deformation element (4) and/or the second deformation element (5) is an electrothermally-deformable deformation element (4, 5).

9. Actuator arrangement (1, 1', 1") according to any one of the preceding claims, **characterized in that** respectively one heating element (33) is arranged on or in the first deformation element (4) of the first actuator (2) and/or on or in the second deformation element (5) of the second actuator (3).

10. Actuator arrangement (1, 1', 1") according to any one of the preceding claims, **characterized in that** starting from a stable deflection position of the two actuators (2, 3), the first deformation trajectory is oriented perpendicularly to the second deformation trajectory.

11. Actuator arrangement (1, 1', 1") according to any one of the preceding claims, **characterized in that** a first orientation directed from the first fastening end (6) to the first deformation end (7) of the first actuator (2) has a positive orientation angle relative to a second orientation directed from the second fastening end (6) to the second deformation end (8) of the second actuator (3) .

12. Actuator arrangement (1, 1', 1") according to any one of the preceding claims, **characterized in that** the first actuator (2) takes a resting position in a non-actuated state and is in engagement with the second actuator (3) in this resting position, wherein the second actuator (3) in at least three different positions can be brought into engagement with the first actuator (2) in the resting position thereof.

13. Actuator arrangement (1, 1', 1") according to any one of the preceding claims, **characterized in that** the first actuator (2) and the second actuator (3) respectively is a micro-actuator.

14. Actuator arrangement (1, 1', 1") according to any one of the preceding claims, **characterized in that** the first deformation element (4) and/or the second deformation element (5) are formed in multiple layers.

15. Actuator arrangement (1, 1', 1") according to any one of the preceding claims, **characterized in that** the first deformation element (4) and/or the second deformation element (5) partially or completely consist of a polymer material.

## Revendications

1. Ensemble d'actionneurs (1, 1', 1") avec un premier actionneur (2) et avec un second actionneur (3), dans lequel le premier actionneur (2) et le second actionneur (3) présentent respectivement un élément de déformation (4, 5), lequel est immobilisé respectivement au niveau d'une extrémité de fixation (6) et présente respectivement une extrémité de déformation (7, 8) faisant face à l'extrémité de fixation (6), qui peut être déviée par déformation de l'élément de déformation (4, 5) par rapport à l'extrémité de fixation (6) sur une trajectoire de déformation, dans lequel la première extrémité de déformation (7) du premier actionneur (2) peut être amenée en prise par déformation de l'élément de déformation (4) avec la seconde extrémité de déformation (8) du second actionneur (3) ou peut être détachée de la seconde extrémité de déformation (8) du second actionneur (3) de sorte que la seconde extrémité de déformation (8) du second actionneur (3) repose sur la première extrémité de déformation (7) du premier actionneur (2) ou la première extrémité de déformation (7) du premier actionneur (2) repose sur la seconde extrémité de déformation (8) du second actionneur (3) et qu'ainsi deux positions de déviation stables du second actionneur (3) sont prédéfinies,
la première extrémité de déformation (7) du premier actionneur (2) présente une première zone de liaison (13) avec au moins une première surface d'appui (17, 36), qui limite une déviation de la seconde extrémité de déformation (8) du second actionneur (3) dans une première direction de déviation (11), et avec au moins une deuxième surface d'appui (18, 37), qui limite une déviation de la seconde extrémité de déformation (8) du second actionneur (3) dans une deuxième direction de déviation (12), qui est opposée à la première direction de déviation (11), quand la seconde extrémité de déformation (8) du second actionneur (3) est en prise avec la première extrémité de déformation (7) du premier actionneur (2) et ce faisant la seconde extrémité de déformation (8) du second actionneur (3) repose au niveau de la première surface d'appui (17, 36) du premier actionneur (2) de sorte que dans au moins une position de déviation du second actionneur (3), une déviation de la seconde extrémité de déformation (8) du second actionneur (3) est limitée dans le même temps dans la première direction de déviation (11) et dans la deuxième direction de déviation (12) par la première surface d'appui (17, 36) et la deuxième surface d'appui (18, 37) du premier actionneur (2) de sorte que la seconde extrémité de déformation (8) du second actionneur (3) peut être amenée en prise dans plusieurs positions de déviation dans la première zone de liaison (13) avec la première extrémité de déformation (7) du premier actionneur (2), **caractérisé en ce que** la première surface d'appui (17, 36) et la deuxième surface d'appui (18, 37) sont disposées l'une par rapport à l'autre de manière décalée dans la première zone de liaison (13) du premier actionneur (2) dans une direction de décalage (16) de manière transversale par rapport à la première et à la deuxième direction de déviation (11, 12) de la seconde extrémité de déformation (8) du second actionneur (3).

2. Ensemble d'actionneurs (1, 1', 1") selon la revendication 1, **caractérisé en ce que** la seconde extrémité de déformation (8) du second actionneur (3) peut être amenée en prise dans au moins trois positions de déviation différentes dans la première zone de liaison (13) avec la première extrémité de déformation (7) du premier actionneur (2).

3. Ensemble d'actionneurs (1, 1', 1") selon l'une quelconque des revendications précédentes, **caractérisé en ce que** la première surface d'appui (17, 36) et la deuxième surface d'appui (18, 37) sont disposées à distance l'une de l'autre dans la première zone de liaison (13) du premier actionneur (2) dans la première direction de déviation (11) .

4. Ensemble d'actionneurs (1, 1', 1") selon l'une quelconque des revendications précédentes, **caractérisé en ce que** la première surface d'appui (17, 36) et la deuxième surface d'appui (18, 37) sont disposées, dans la première zone de liaison (13) du premier actionneur (2), à la fois de manière décalée l'une par rapport à l'autre dans une direction de décalage (16) de manière transversale par rapport à la première et à la deuxième direction de déviation (11, 12) de la seconde extrémité de déformation (8) du second actionneur (3) et à distance l'une par rapport à l'autre dans la première direction de déviation (11) .

5. Ensemble d'actionneurs (1, 1', 1") selon l'une quelconque des revendications précédentes, **caractérisé en ce que** dans la première zone de liaison (13) du premier actionneur (2) est réalisé au moins un évidement (34) limité de part et d'autre, dont les surfaces de bord latéral se faisant face disposées à distance les unes par rapport aux autres dans la première direction de déviation (11) forment la première surface d'appui (36) et la deuxième surface d'appui (37), ce qui permet de former une première zone de liaison (13) configurée à la manière d'un peigne.

6. Ensemble d'actionneurs (1, 1', 1") selon l'une quelconque des revendications précédentes, **caractérisé en ce que** dans une seconde zone de liaison (19), est réalisé, au niveau de la seconde extrémité de déformation (8) du second actionneur (3), au moins un évidement (34) limité de part et d'autre, dont les surfaces de bord latéral se faisant face disposées à distance les unes par rapport aux autres dans la première direction de déviation (11) forment une première surface d'appui (36) et une deuxième surface d'appui (37), ce qui permet de former une seconde zone de liaison (19), configurée à la manière d'un peigne, du second actionneur (2).

7. Ensemble d'actionneurs (1, 1', 1") selon la revendication 6 ou la revendication 7, **caractérisé en ce que** la première zone de liaison (13) du premier actionneur (2) et/ou la seconde zone de liaison (19) du second actionneur (3) présentent deux ou plus de deux évidements (34) limités de part et d'autre.

8. Ensemble d'actionneurs (1, 1', 1") selon l'une quelconque des revendications précédentes, **caractérisé en ce que** le premier élément de déformation (4) et/ou le second élément de déformation (5) sont un élément de déformation (4, 5) pouvant être déformé de manière électrothermique.

9. Ensemble d'actionneurs (1, 1', 1") selon l'une quelconque des revendications précédentes, **caractérisé en ce que** respectivement un élément de chauffage (33) est disposé au niveau de ou dans le premier élément de déformation (4) du premier actionneur (2) et/ou au niveau de ou dans le second élément de déformation (5) du second actionneur (3).

10. Ensemble d'actionneurs (1, 1', 1") selon l'une quelconque des revendications précédentes, **caractérisé en ce que** la première trajectoire de déformation est dirigée de manière perpendiculaire par rapport à la seconde trajectoire de déformation hors d'une position de dérivation stable des deux actionneurs (2, 3).

11. Ensemble d'actionneurs (1, 1', 1") selon l'une quelconque des revendications précédentes, **caractérisé en ce qu'**une première orientation dirigée depuis la première extrémité de fixation (6) vers la première extrémité de déformation (7) du premier actionneur (2) présente un angle d'orientation positif par rapport à une deuxième orientation dirigée depuis la seconde extrémité de fixation (6) vers la seconde extrémité de déformation (8) du second actionneur (3).

12. Ensemble d'actionneurs (1, 1', 1") selon l'une quelconque des revendications précédentes, **caractérisé en ce que** le premier actionneur (2) adopte, dans un état non actionné, une position de repos et est en prise, dans ladite position de repos, avec le second actionneur (3), dans lequel le second actionneur (3) peut être amené en prise dans au moins trois positions différentes avec le premier actionneur (2) dans sa position de repos.

13. Ensemble d'actionneurs (1, 1', 1") selon l'une quelconque des revendications précédentes, **caractérisé en ce que** le premier actionneur (2) et le second actionneur (3) sont respectivement un micro-actionneur.

14. Ensemble d'actionneurs (1, 1', 1") selon l'une quelconque des revendications précédentes, **caractérisé en ce que** le premier élément de déformation (4) et/ou le second élément de déformation (5) sont configurés de manière multicouche.

15. Ensemble d'actionneurs (1, 1', 1") selon l'une quelconque des revendications précédentes, **caractérisé en ce que** le premier élément de déformation (4) et/ou le second élément de déformation (5) sont constitués en partie ou en totalité d'un matériau polymère.
